# EUROPEAN PATENT APPLICATION

(11) **EP 4 826 454 A1**
(43) Date of publication of application: **21.10.2026**
(21) Application number: 24912654.1
(22) Date of filing: 20.12.2024
(51) Int. Cl.: G03F 7/32, H01L 21/304

(54) **CONTAINER-LOADED CHEMICAL LIQUID FOR SEMICONDUCTOR PRODUCTION, METHOD FOR PRODUCING CONTAINER-LOADED CHEMICAL LIQUID FOR SEMICONDUCTOR PRODUCTION, AND METHOD FOR PRESERVING CHEMICAL LIQUID FOR SEMICONDUCTOR PRODUCTION**

(30) Priority: 27.12.2023 JP 2023221881
(71) Applicant: Tokyo Ohka Kogyo Co., Ltd., Kawasaki-shi, Kanagawa 211-0012 (JP)
(72) Inventor: TAKAHASHI, Motoki, Kawasaki-shi, Kanagawa 211-0012 (JP); SOEDA, Kuniteru, Kawasaki-shi, Kanagawa 211-0012 (JP); WATANO, Manami, Kawasaki-shi, Kanagawa 211-0012 (JP)
(74) Representative: Plasseraud IP
(86) International application number: PCT/JP2024/045126
(87) International publication number: WO 2025/142765

(57) **Abstract**

Provided are a semiconductor-manufacturing chemical liquid packaged in a container, in which the semiconductor-manufacturing chemical liquid is contained in the container, the container contains an austenitic stainless steel subjected to passivation treatment as a base material, a surface subjected to the passivation treatment is an inner surface of the container, the semiconductor-manufacturing chemical liquid contains one or more metal components selected from the group consisting of V, Sn, and Pb, and an organic solvent, and a content of the metal component after 30 days have elapsed from a time of filling into the container is 0.1 ppt by mass to 1 ppm by mass; a method for producing a semiconductor-manufacturing chemical liquid packaged in a container; and a method for storing a semiconductor-manufacturing chemical liquid.

## Description

### Technical Field

The present invention relates to a semiconductor-manufacturing chemical liquid packaged in a container, a method for producing a semiconductor-manufacturing chemical liquid packaged in a container, and a method for storing a semiconductor-manufacturing chemical liquid.

### Background Art

A semiconductor device is formed by stacking a low dielectric layer, an insulating layer, a metal wiring (layer), and the like on a substrate such as a silicon wafer, and such a semiconductor device is manufactured by forming the above-described layers and metal wiring by a lithography method in which etching treatment is performed using a resist pattern as a mask.

In a process for manufacturing a semiconductor device including the above-described lithography step, various semiconductor-manufacturing chemical liquids are used as a resist liquid, a developer, a stripping liquid, a cleaning liquid, a pre-rinse liquid, a rinse liquid, a chemical mechanical polishing (CMP) slurry, and the like.

Regarding such a technique, for example, Patent Literature 1 discloses a chemical liquid container body having a container and a chemical liquid contained in the container, in which the chemical liquid contains a solvent, metal-containing particles including metal atoms, and an organic compound having a ClogP value higher than that of the solvent, a content of the metal-containing particles is 10 ppt by mass or less with respect to the total mass of the chemical liquid, a gas including an organic compound having a ClogP value higher than that of the solvent is present in a void portion of the container, and a total content of the organic compound in the gas and the organic compound in the chemical liquid is 100,000 ppt by mass or less with respect to the total mass of the chemical liquid.

### Patent Literature

Patent Literature 1: WO 2020/040034

### Summary of Invention

### Technical Problem

Incidentally, when fine particles are included in a semiconductor-manufacturing chemical liquid, the fine particles cause defects in a semiconductor device. However, as a result of intensive studies by the present inventors, the present inventors found that, based only on the simple idea that the content of particles in a semiconductor-manufacturing chemical liquid should be lowered, suppression of an increase in particles in the chemical liquid over time with the lapse of storage days and suppression of occurrence of defects cannot both be achieved.

The present invention has been made in view of the above circumstances, and an object of the present invention is to provide a semiconductor-manufacturing chemical liquid packaged in a container, a method for producing a semiconductor-manufacturing chemical liquid packaged in a container, and a method for storing a semiconductor-manufacturing chemical liquid, each capable of suppressing an increase in particles in the chemical liquid over time and also suppressing occurrence of defects.

### Solution to Problem

As a result of intensive studies to achieve the above-described object, the present inventors obtained knowledge by providing a semiconductor-manufacturing chemical liquid that is contained in a container, in which the container contains an austenitic stainless steel subjected to passivation treatment as a base material, a surface subjected to the passivation treatment is an inner surface of the container, the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass, and the present inventors have completed the present invention.

That is, the present invention is as follows.
<1> A semiconductor-manufacturing chemical liquid packaged in a container, the semiconductor-manufacturing chemical liquid being contained in the container, in which the container contains an austenitic stainless steel subjected to passivation treatment as a base material, and a surface subjected to the passivation treatment is an inner surface of the container, the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass.
<2> The semiconductor-manufacturing chemical liquid packaged in a container according to <1>, in which the semiconductor-manufacturing chemical liquid contains two or more metal components selected from the group consisting of V, Sn, and Pb, a content of each of the two or more metal components in the semiconductor-manufacturing chemical liquid after 30 days have elapsed from a time of filling into the container is 1 ppm by mass or less, and a content of at least one metal component among the two or more metal components in the semiconductor-manufacturing chemical liquid after 30 days have elapsed from a time of filling into the container is 1 ppt by mass or more.
<3> The semiconductor-manufacturing chemical liquid packaged in a container according to <1> or <2>, in which a ratio of a concentration of the metal component in the container after 30 days have elapsed from a time of filling into the container to a concentration of the metal component in the container at the time of filling into the container (after 30 days have elapsed from the time of filling/at the time of filling) is 1 or more and 1.5 or less.
<4> The semiconductor-manufacturing chemical liquid packaged in a container according to any one of <1> to <3>, in which the semiconductor-manufacturing chemical liquid contains, as the organic solvent, one or more selected from the group consisting of an alkylene glycol monoalkyl ether, an alkylene glycol monoalkyl ether acetate, cyclohexanone, cyclopentanone, 2-heptanone, γ-butyrolactone, ethyl lactate, butyl acetate, and 3-methoxybutyl acetate.
<5> The semiconductor-manufacturing chemical liquid packaged in a container according to any one of <1> to <4>, in which the semiconductor-manufacturing chemical liquid contains two or more of the organic solvents.
<6> The semiconductor-manufacturing chemical liquid packaged in a container according to any one of <1> to <5>, in which the passivation treatment is a GEP treatment or a GEPW treatment.
<7> The semiconductor-manufacturing chemical liquid packaged in a container according to any one of <1> to <6>, in which the semiconductor-manufacturing chemical liquid is a semiconductor-manufacturing developer or a semiconductor-manufacturing rinse liquid.
<8> A method for producing a semiconductor-manufacturing chemical liquid packaged in a container, the semiconductor-manufacturing chemical liquid being contained in the container, the method including: a step of preparing, as the container, a container containing an austenitic stainless steel subjected to passivation treatment as a base material and having a surface subjected to the passivation treatment as an inner surface; and a step of filling the container with the semiconductor-manufacturing chemical liquid, in which the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass.
<9> A method for storing a semiconductor-manufacturing chemical liquid, the method including: a step of preparing a container containing an austenitic stainless steel subjected to passivation treatment as a base material and having a surface subjected to the passivation treatment as an inner surface; and a step of filling the container with a semiconductor-manufacturing chemical liquid, in which the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass.

### Advantageous Effects of Invention

According to the present invention, it is possible to provide the semiconductor-manufacturing chemical liquid packaged in a container, the method for producing a semiconductor-manufacturing chemical liquid packaged in a container, and the method for storing a semiconductor-manufacturing chemical liquid, each capable of suppressing an increase in particles in the chemical liquid over time and also suppressing occurrence of defects.

### Description of Embodiments

Hereinafter, a mode for carrying out the present invention (hereinafter simply referred to as the "present embodiment") will be described in detail. The present embodiment described below is an example for describing the present invention and is not intended to limit the present invention to the following contents. The present invention may be carried out with appropriate modifications within the scope of the gist of the present invention. In addition, each configuration and parameter disclosed in the present specification may be in any combination unless otherwise specified. Furthermore, the upper limit and the lower limit of values disclosed in the present specification may be in any combination unless otherwise specified.

### <Semiconductor-Manufacturing Chemical Liquid>

The semiconductor-manufacturing chemical liquid according to the present embodiment (hereinafter sometimes simply abbreviated as the "chemical liquid") is a semiconductor-manufacturing chemical liquid packaged in a container, the semiconductor-manufacturing chemical liquid being contained in the container, in which the container contains an austenitic stainless steel subjected to passivation treatment as a base material, a surface subjected to the passivation treatment is an inner surface of the container, the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass. By using such a chemical liquid, an increase in particles in the chemical liquid over time can be suppressed, and occurrence of defects can also be suppressed.

Conventionally, with regard to a semiconductor-manufacturing chemical liquid, studies had merely been made based on the simple idea that fine particles capable of becoming particles should be removed, based on the knowledge that fewer particles in the chemical liquid are better for suppressing occurrence of defects. However, the present inventors did not remain with such a simple idea and focused on the fact that defects may not be sufficiently suppressed merely by reducing the concentration of fine particles.

As a result of intensive studies by the present inventors, regarding semiconductor-manufacturing chemical liquids used in applications such as a resist liquid, a developer, a stripping liquid, a cleaning liquid, a pre-rinse liquid, a rinse liquid, and a chemical mechanical polishing (CMP) slurry, the present inventors unexpectedly obtained knowledge that controlling contents of specific metal components (metal components) such as V, Sn, and Pb is effective for suppressing defects in a semiconductor device or the like. Furthermore, the present inventors also obtained knowledge that, while the above chemical liquid in which metal components such as V, Sn, and Pb are contained at specific contents is stored in a SUS container or the like conventionally widely used, contents of various metals increase over time as the storage period advances until the time of use, and such an increase is also one cause of insufficient suppression of defects.

The chemical liquid according to the present embodiment has been made based on the above knowledge and the like, and is a semiconductor-manufacturing chemical liquid packaged in a container, the semiconductor-manufacturing chemical liquid being contained in the container, in which the container contains an austenitic stainless steel subjected to passivation treatment as a base material, a surface subjected to the passivation treatment is an inner surface of the container, the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass, whereby, unexpectedly, an increase in particles in the chemical liquid over time and occurrence of defects can be suppressed, and occurrence of defects at the time of use of the chemical liquid can also be suppressed to an extent that was not achievable conventionally (however, the actions and effects of the present embodiment are not limited to the above-described contents).

### (Container)

The container contains an austenitic stainless steel subjected to passivation treatment as a base material, and a surface subjected to the passivation treatment is an inner surface of the container. The austenitic stainless steel is not particularly limited, and examples of the austenitic stainless steel may include steel use stainless (SUS) 304 (Ni content: 8% by mass, Cr content: 18% by mass), SUS304L (Ni content: 9% by mass, Cr content: 18% by mass), SUS316 (Ni content: 10% by mass, Cr content: 16% by mass), SUS316L (Ni content: 12% by mass, Cr content: 16% by mass), and the like.

In the container of the present embodiment, a passive layer (sometimes called a passive film, a passivation film, or the like) is formed and/or grown by passivation treatment, and therefore elution of a metal component into the chemical liquid can be suppressed over a long period. The passive layer referred to herein does not encompass an oxide film or the like inevitably formed by an oxidation reaction with oxygen in air, but refers to, for example, a passive layer or the like intentionally formed by passivation treatment. From such a viewpoint, the passive layer is preferably uniformly formed on the surface.

The method of the passivation treatment is not particularly limited, but preferably includes heat oxidation treatment and/or electro polishing (EP) treatment, more preferably both heat oxidation treatment and electro polishing treatment are performed, and still more preferably heat oxidation treatment is performed after electro polishing treatment is performed. By employing these treatment methods, the passive layer can be formed still more uniformly on the inner surface of the container, and pinholes in the barrier of the passive layer can be suppressed still more effectively.

Furthermore, the passivation treatment is preferably a gold electro polishing (GEP) treatment or a gold electro polishing white (GEPW) treatment.

In the case of the GEP treatment, heat oxidation treatment is performed after electro polishing treatment (EP treatment) is performed. Thereby, a surface iron oxide layer and a lower chromium oxide layer can be grown. As a result, unintended elution of particles such as metal components into the chemical liquid contained in the container can be suppressed still more effectively.

In the case of the GEPW treatment, heat oxidation treatment is performed after electro polishing treatment (EP treatment) is performed, and further, a surface iron oxide layer is removed to leave a grown chromium oxide layer. As a result, unintended elution of particles such as metal components into the chemical liquid contained in the container can be suppressed still more effectively.

As described above, the GEP treatment and the GEPW treatment can be performed as additional treatments following electro polishing (EP), and a passive layer can be grown on the stainless steel serving as the base material. Furthermore, the GEP treatment and the GEPW treatment can be selectively used according to the composition of the chemical liquid. For example, when the chemical liquid contains a large amount of alcohols or the like, the GEP treatment is suitable, and when the chemical liquid contains a large amount of amines or the like, the GEPW treatment is suitable. In addition, the GEP treatment and the GEPW treatment would also be selectively usable according to the degree of dissolved oxygen content of the chemical liquid (however, the actions and effects of the present embodiment are not limited thereto).

### (Components of Chemical Liquid)

The semiconductor-manufacturing chemical liquid contains one or more metal components selected from the group consisting of V, Sn, and Pb. V, Sn, and Pb may be present in the chemical liquid as particles of elemental metals, or may be eluted into the chemical liquid as metal ions.

Regarding the content of the metal component in the semiconductor-manufacturing chemical liquid, the content of the metal component in the semiconductor-manufacturing chemical liquid after 30 days have elapsed from a time of filling into the container (sometimes abbreviated as the "post-elapse content") is 0.1 ppt by mass to 1 ppm by mass (1,000,000 ppt by mass). The lower limit of the content of the metal component is preferably 0.5 ppt by mass or more, more preferably 2 ppt by mass or more, still more preferably 5 ppt by mass or more, and even still more preferably 50 ppt by mass or more. The upper limit of the content of the metal component is preferably 500000 ppt by mass or less, more preferably 50000 ppt by mass or less, still more preferably 5000 ppt by mass or less, yet even still more preferably 650 ppt by mass or less, and yet even still more preferably 500 ppt by mass or less. When the above post-elapse content of the metal component is within the above numerical range, occurrence of defects can be suppressed still more effectively. In addition, when two or more of V, Sn, and Pb are contained as the metal component, the total content of the metal components is more preferably within the above range.

Furthermore, regarding the content of the metal component in the semiconductor-manufacturing chemical liquid, the content of the metal component in the semiconductor-manufacturing chemical liquid immediately after container filling (sometimes abbreviated as the "post-filling content") is preferably 0.1 ppt by mass to 1 ppm by mass (1,000,000 ppt by mass). The lower limit of the content of the metal component is preferably 0.5 ppt by mass or more, more preferably 5 ppt by mass or more, and still more preferably 50 ppt by mass or more. The upper limit of the content of the metal component is more preferably 500000 ppt by mass or less, still more preferably 50000 ppt by mass or less, even still more preferably 5000 ppt by mass or less, yet even still more preferably 600 ppt by mass or less, and yet even still more preferably 500 ppt by mass or less. When the above post-elapse content of the metal component is within the above numerical range, the post-elapse content of the metal component can be controlled with still higher accuracy so as to be within the above numerical range, and occurrence of defects can also be suppressed still more effectively. In addition, when two or more of V, Sn, and Pb are contained as the metal component, the total content of the metal components is more preferably within the above range.

When the semiconductor-manufacturing chemical liquid contains two or more metal components selected from the group consisting of V, Sn, and Pb, the content of each of the two or more metal components in the semiconductor-manufacturing chemical liquid after 30 days have elapsed from a time of filling into the container is preferably 1 ppm by mass or less, and the content of at least one metal component among the two or more metal components in the semiconductor-manufacturing chemical liquid after 30 days have elapsed from a time of filling into the container is preferably 1 ppt by mass or more.

The upper limit of the content of each of the two or more metal components in the semiconductor-manufacturing chemical liquid after 30 days have elapsed from a time of filling into the container is more preferably 900000 ppt by mass or less, still more preferably 100000 ppt by mass or less, even still more preferably 500 ppt by mass or less, and yet even still more preferably 450 ppt by mass or less. The lower limit of this content is preferably greater than 0 ppt by mass, more preferably 0.01 ppt by mass or more, and still more preferably 0.1 ppt by mass or more.

In addition, the upper limit of the content of at least one metal component among the two or more metal components in the semiconductor-manufacturing chemical liquid after 30 days have elapsed from a time of filling into the container is preferably 900000 ppt by mass or less, more preferably 100000 ppt by mass or less, still more preferably 500 ppt by mass or less, and even still more preferably 450 ppt by mass or less. The lower limit of this content is preferably greater than 0 ppt by mass, more preferably 0.01 ppt by mass or more, still more preferably 0.1 ppt by mass or more, and even still more preferably 1 ppt by mass or more.

According to the present embodiment, as described above, an increase in particles in the chemical liquid over time can be suppressed, and therefore an increase in the above-described concentration of the metal component in the container can be suppressed over a long period. Preferred examples of such an aspect may include, for example, an aspect in which a ratio of the concentration of the metal component in the container after 30 days have elapsed from a time of filling into the container to the concentration of the metal component in the container at the time of filling into the container (after 30 days have elapsed from the time of filling/at the time of filling) is 1 or more and 1.5 or less. The lower limit of this ratio of the concentration in the container is preferably 1.00 or more, and more preferably 1.05 or more. The upper limit of this ratio is not particularly limited, but is preferably 10 or less, more preferably 5 or less, still more preferably 3 or less, even still more preferably 2.5 or less, and yet even still more preferably 1.5 or less. When the above ratio is within the above numerical range, suppression of an increase in particles in the chemical liquid over time with the lapse of storage days and suppression of occurrence of defects can both be achieved at a still higher level.

The semiconductor-manufacturing chemical liquid contains an organic solvent. The organic solvent is not particularly limited, but is preferably one or more selected from the group consisting of an alcohol-based solvent, a glycol ether-based solvent, a glycol ester-based solvent, a ketone-based solvent, a lactone-based solvent, an ester-based solvent, a sulfonic acid-based solvent, an amide-based solvent, and a pyrrolidone-based solvent.

Specific examples of the alcohol-based solvent may include aliphatic alcohols such as methanol, ethanol, denatured ethanol, isopropanol, n-propanol, n-butanol, and 3-methoxy-3-methyl-1-butanol; glycols such as ethylene glycol, diethylene glycol, propylene glycol, dipropylene glycol, glycerin, 1,3-propanediol, 1,3-butanediol, 1,4-butanediol, furfuryl alcohol, and hexylene glycol; and the like.

Specific examples of the glycol ether-based solvent may include an alkylene glycol monoalkyl ether, an alkylene glycol dialkyl ether, a polymer-type polyalkylene glycol ether-based solvent, and the like.

Examples of the alkylene glycol monoalkyl ether may include ethylene-based glycol monoalkyl ethers such as ethylene glycol monomethyl ether, diethylene glycol monomethyl ether, triethylene glycol monomethyl ether, ethylene glycol monoethyl ether, ethylene glycol monobutyl ether, diethylene glycol monobutyl ether, triethylene glycol monobutyl ether, ethylene glycol monohexyl ether, and diethylene glycol monohexyl ether; propylene-based glycol monoalkyl ethers such as propylene glycol monomethyl ether (PGME), propylene glycol monoethyl ether, propylene glycol monopropyl ether, propylene glycol monobutyl ether, dipropylene glycol monomethyl ether (DPM), dipropylene glycol monoethyl ether, dipropylene glycol monopropyl ether, dipropylene glycol monobutyl ether, tripropylene glycol monomethyl ether, tripropylene glycol monoethyl ether, and tripropylene glycol monobutyl ether; and the like.

Examples of the alkylene glycol dialkyl ether may include ethylene-based glycol dialkyl ethers such as ethylene glycol dimethyl ether, diethylene glycol dimethyl ether, triethylene glycol dimethyl ether, ethylene glycol diethyl ether, ethylene glycol dibutyl ether, diethylene glycol dibutyl ether, triethylene glycol dibutyl ether, ethylene glycol dihexyl ether, and diethylene glycol dihexyl ether; propylene-based glycol dialkyl ethers such as propylene glycol dimethyl ether, propylene glycol diethyl ether, propylene glycol dipropyl ether, propylene glycol dibutyl ether, dipropylene glycol dimethyl ether, dipropylene glycol diethyl ether, dipropylene glycol dipropyl ether, dipropylene glycol dibutyl ether, tripropylene glycol dimethyl ether, tripropylene glycol diethyl ether, and tripropylene glycol dibutyl ether; and the like.

Examples of the polyalkylene glycol ether may include polyalkylene glycol ethers such as polyoxypropylene butyl ether, polyoxyethylene polyoxypropylene butyl ether, polyoxyethylene oleyl ether, and polyoxyethylene polyoxypropylene-2-ethylhexyl ether, and the like.

Among these, an ethylene-based glycol monoalkyl ether, a propylene-based glycol monoalkyl ether, an ethylene-based glycol dialkyl ether, a propylene-based glycol dialkyl ether, and the like are preferable, and propylene glycol monomethyl ether (PGME) and the like are more preferable.

Specific examples of the glycol ester-based solvent may include an alkylene glycol monoalkyl ether acetate and the like.

Examples of the alkylene glycol monoalkyl ether acetate may include ethylene-based glycol ether acetates such as ethylene glycol monobutyl ether acetate and diethylene glycol monobutyl ether acetate; propylene-based glycol ether acetates such as propylene glycol monomethyl ether acetate (PGMEA), dipropylene glycol monomethyl ether acetate, and propylene glycol diacetate; and the like.

Among these, ethylene-based glycol ether acetates and propylene-based glycol ether acetates are preferable, and propylene glycol monomethyl ether acetate (PGMEA) and the like are more preferable.

Specific examples of the ketone-based solvent may include acetone, methyl ethyl ketone (MEK), methyl isobutyl ketone (MIBK), diisobutyl ketone, cyclohexanone, cyclopentanone, diacetone alcohol, 1-hexanone, 2-hexanone, 4-heptanone, 2-heptanone, 1-octanone, 2-octanone, 1-nonanone, 2-nonanone, acetylacetone, acetonylacetone, phenylacetone, acetophenone, methyl naphthyl ketone, methylcyclohexanone, ionone, isophorone, propylene carbonate, diacetonyl alcohol, acetylcarbinol, and the like.

Among these, cyclohexanone, cyclopentanone, 2-heptanone, and the like are preferable.

Specific examples of the lactone-based solvent may include γ-butyrolactone, α-methyl-γ-butyrolactone, β-propiolactone, γ-valerolactone, δ-valerolactone, γ-caprolactone, ε-caprolactone, γ-laurolactone, hexanolactone, and the like.

Among these, γ-butyrolactone and the like are preferable.

Specific examples of the ester-based solvent may include methyl acetate, ethyl acetate, butyl acetate, amyl acetate, propyl acetate, isopropyl acetate, methyl lactate, ethyl lactate, butyl lactate, ethyl methoxyacetate, ethyl ethoxyacetate, 2-methoxybutyl acetate, 3-methoxybutyl acetate, 4-methoxybutyl acetate, 3-methoxy-3-methylbutyl acetate, 3-ethyl-3-methoxybutyl acetate, 4-methyl-4-methoxypentyl acetate, methyl formate, ethyl formate, propyl formate, butyl formate, ethyl lactate, propyl lactate, butyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl 3-methoxypropionate, ethyl 3-methoxypropionate, ethyl 3-ethoxypropionate, propyl 3-methoxypropionate, and the like.

Among these, ethyl acetate, butyl acetate, ethyl lactate, butyl lactate, 3-methoxybutyl acetate, and the like are preferable.

Specific examples of the sulfonic acid-based solvent may include, for example, dimethyl sulfone, diethyl sulfone, tetramethylene sulfone, dipropyl sulfone, sulfolane (also known as tetramethylene sulfone), 3-methylsulfolane, 2,4-dimethylsulfolane, 3,4-dimethylsulfolane, diphenylsulfolane, 3,4-diphenylmethylsulfolane, sulfolene, 3-methylsulfolene, 3-ethylsulfolene, and the like.

Specific examples of the amide-based solvent may include, for example, N,N-dimethylformamide (DMF), diethylformamide (DEF), N,N-dimethylacetamide (DMAc), N-methylpyrrolidine (MPD), hexamethylphosphoric triamide (HMPA), and the like.

Specific examples of the pyrrolidone-based solvent may include, for example, N-methylpyrrolidone (NMP), 2-pyrrolidone, N-vinyl-2-pyrrolidone, and the like.

Among the above, the chemical liquid preferably contains one or more selected from the group consisting of an alcohol-based solvent, a glycol ether-based solvent, a glycol ester-based solvent, a ketone-based solvent, a lactone-based solvent, and an ester-based solvent; and more preferably contains one or more selected from the group consisting of an alkylene glycol monoalkyl ether, an alkylene glycol monoalkyl ether acetate, cyclohexanone, cyclopentanone, 2-heptanone, γ-butyrolactone, ethyl lactate, butyl acetate, and 3-methoxybutyl acetate.

The semiconductor-manufacturing chemical liquid may contain one kind of organic solvent, or may contain two or more thereof, but preferably contains two or more organic solvents. As preferred examples in the case of containing two or more organic solvents, two or more of the above-described organic solvents can be selected. Furthermore, as a preferred combination when two or more organic solvents are contained, the chemical liquid preferably contains two or more selected from the group consisting of an alcohol-based solvent, a glycol ether-based solvent, a glycol ester-based solvent, a ketone-based solvent, a lactone-based solvent, an ester-based solvent, a sulfonic acid-based solvent, an amide-based solvent, and a pyrrolidone-based solvent. As preferred examples thereof, the preferred examples described above can be selected respectively.

As one example of preferred examples of the combination in the case of containing two or more organic solvents, for example, the chemical liquid preferably contains (i) at least one glycol ether-based solvent or glycol ester-based solvent and (ii) one or more selected from the group consisting of an alcohol-based solvent, a glycol ether-based solvent, a glycol ester-based solvent, a ketone-based solvent, a lactone-based solvent, and an ester-based solvent; and more preferably contains at least (i) a glycol ether-based solvent and (ii) a glycol ester-based solvent.

The preferred content ratio of the above-described (i) and (ii) is, in terms of volume ratio, preferably (i):(ii)=1:9 to 9:1, more preferably 3:7 to 9:1, and still more preferably 5:5 to 9:1. For example, when the mixed solvent contains two organic solvents in which (i) is propylene glycol monomethyl ether (PGME) and (ii) is propylene glycol monomethyl ether acetate (PGMEA), the content ratio of PGME and PGMEA (PGME:PGMEA) is, in terms of volume ratio, preferably 1:9 to 9:1, more preferably 3:7 to 9:1, and still more preferably 5:5 to 9:1.

Alternatively, as another aspect, the chemical liquid preferably contains two or more selected from the group consisting of an alkylene glycol monoalkyl ether, an alkylene glycol monoalkyl ether acetate, cyclohexanone, cyclopentanone, 2-heptanone, γ-butyrolactone, ethyl lactate, butyl acetate, and 3-methoxybutyl acetate, and more preferably contains (a) at least one alkylene glycol monoalkyl ether or an alkylene glycol monoalkyl ether acetate and (b) one or more selected from the group consisting of an alkylene glycol monoalkyl ether, an alkylene glycol monoalkyl ether acetate, cyclohexanone, cyclopentanone, 2-heptanone, γ-butyrolactone, ethyl lactate, butyl acetate, and 3-methoxybutyl acetate.

The preferred content ratio of the above-described (a) and (b) is, in terms of volume ratio, preferably (a):(b)=1:9 to 9:1, more preferably 3:7 to 9:1, and still more preferably 5:5 to 9:1. For example, when the mixed solvent contains two organic solvents in which (a) is propylene glycol monomethyl ether (PGME) and (b) is alkylene glycol monoalkyl ether propylene glycol monomethyl ether acetate (PGMEA), the content ratio of PGME and PGMEA (PGME:PGMEA) is, in terms of volume ratio, preferably 1:9 to 9:1, more preferably 3:7 to 9:1, and still more preferably 5:5 to 9:1.

By using the combination of organic solvents as described above, suppression of an increase in particles in the chemical liquid over time and suppression of occurrence of defects can both be achieved at a still higher level.

The content of the organic solvent is preferably 90% to 100% by mass with respect to the total amount of the chemical liquid. This lower limit is more preferably 95% by mass or more, and still more preferably 99% by mass or more. This upper limit is preferably less than 100% by mass.

The chemical liquid according to the present embodiment may contain water. Water may be added to the chemical liquid, or may be unintentionally mixed into the chemical liquid in a process for manufacturing the chemical liquid. For example, in a case where a water-soluble organic solvent is contained as the organic solvent, even when the water-soluble organic solvent is used in combination with water, an increase in particles in the chemical liquid over time and occurrence of defects can be sufficiently suppressed. The content of water may be included as the remainder of components other than water. The content of water may be, for example, 0.001% by mass to 2.0% by mass with respect to the total amount of the chemical liquid. This lower limit may be 0.005% by mass or more, or may be 0.01% by mass or more. This upper limit may be 1.5% by mass or less, or may be 1.0% by mass or less. The content of water in the chemical liquid can be measured by a Karl Fischer measurement method.

The chemical liquid according to the present embodiment may further contain other components according to the application, provided that the effects of the present embodiment are obtained. Examples may include an antioxidant (for example, dibutylhydroxytoluene and the like), an acid generator, a basic compound, an acid diffusion control agent, a stabilizer, a hydrophobic resin, a surfactant, and the like. Publicly known components can be appropriately adopted according to the application.

The chemical liquid according to the present embodiment can be used as various chemical liquids used in a process for manufacturing a semiconductor device, and can be suitably used, for example, as a resist liquid, a developer, a stripping liquid, a cleaning liquid, a pre-rinse liquid, a rinse liquid, a chemical mechanical polishing (CMP) slurry, and the like. In particular, the chemical liquid can be more suitably used as a semiconductor-manufacturing developer or a semiconductor-manufacturing rinse liquid (also including the above pre-rinse liquid). Since these applications do not require addition of fine components other than the metal components V, Sn, and Pb, the advantages of the present embodiment, namely, the ability to suppress an increase in particles in the chemical liquid over time and also suppress occurrence of defects, can be particularly effectively utilized. In addition, there is also an advantage that the product life can be extended in that changes over time can be suppressed.

The chemical liquid according to the present embodiment can be used as a container body of a semiconductor-manufacturing chemical liquid stored in the above-described container. That is, a container body of a semiconductor-manufacturing chemical liquid including the semiconductor-manufacturing chemical liquid according to the present embodiment and a container containing the semiconductor-manufacturing chemical liquid can be provided.

### <Method for Producing Semiconductor-Manufacturing Chemical Liquid Packaged in Container>

A preferred aspect of the method for producing a semiconductor-manufacturing chemical liquid packaged in a container according to the present embodiment may include a method for producing a semiconductor-manufacturing chemical liquid packaged in a container, in which the semiconductor-manufacturing chemical liquid is contained in the container, the method including a step of preparing, as the container, a container containing an austenitic stainless steel subjected to passivation treatment as a base material and having a surface subjected to the passivation treatment as an inner surface, and a step of filling the container with a semiconductor-manufacturing chemical liquid, in which the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass. The above-described components can be appropriately adopted as the components to be blended in the semiconductor-manufacturing chemical liquid. In addition, the above-described conditions can also be appropriately adopted for numerical values such as contents relating to the semiconductor-manufacturing chemical liquid. A method for mixing the components and the like is not particularly limited, and a publicly known method can be appropriately adopted. In addition, purification treatment such as a distillation step, a filtration step using a filter or the like, and a degassing step may be performed as necessary.

### <Method for Storing Semiconductor-Manufacturing Chemical Liquid>

As described above, according to the present embodiment, at least the advantage of suppressing an increase in particles in the chemical liquid over time is provided so that defects do not occur during use in film formation or the like and so that a sufficient effect of suppressing occurrence of defects can be exhibited. From such a viewpoint, the present embodiment is suitable as a method for storing a semiconductor-manufacturing chemical liquid.

A preferred aspect of the method for storing a semiconductor-manufacturing chemical liquid according to the present embodiment may include a method for storing a semiconductor-manufacturing chemical liquid, the method including a step of preparing a container containing an austenitic stainless steel subjected to passivation treatment as a base material and having a surface subjected to the passivation treatment as an inner surface, and a step of filling the container with a semiconductor-manufacturing chemical liquid, in which the semiconductor-manufacturing chemical liquid contains one or more metal components selected from the group consisting of V, Sn, and Pb, and an organic solvent, and a content of the metal component in the semiconductor-manufacturing chemical liquid after 30 days have elapsed from a time of filling into the container is 0.1 ppt by mass to 1 ppm by mass. During storage, a publicly known treatment such as filling the inside of the container with an inert gas such as nitrogen gas may be performed as necessary. The above-described components can be appropriately adopted as the components of the semiconductor-manufacturing chemical liquid. In addition, the above-described conditions can also be appropriately adopted for numerical values such as contents relating to the semiconductor-manufacturing chemical liquid.

As described above, according to the present embodiment, by controlling contents of trace metal components such as V, Sn, and Pb that cause occurrence of defects, a semiconductor-manufacturing chemical liquid packaged in a container, a method for producing a semiconductor-manufacturing chemical liquid packaged in a container, and a method for storing a semiconductor-manufacturing chemical liquid, each capable of suppressing an increase in particles in the chemical liquid over time and also suppressing occurrence of defects, can be achieved.

### Examples

The present invention will be described in further detail by the following Examples and Comparative Examples, but the present invention is not limited in any way by the following Examples. Unless otherwise specified below, quantities are on a mass basis, and experiments were performed under conditions of 25°C and atmospheric pressure.

In preparing the chemical liquid, unless otherwise specified, handling of the container, preparation of the chemical liquid, containment into the container, storage, and analytical measurement were performed in a clean room. Sampling of a sample from inside the container was performed in an ISO Class 1000 clean room, and other work was performed in an ISO Class 5 clean room. In order to improve measurement accuracy, in measurement of the content of the metal component, when measuring a component at or below the detection limit in ordinary measurement, the chemical liquid was concentrated and measured, and the content was calculated by conversion to the concentration of the solution before concentration.

### <Organic Solvent>

The organic solvents described in Table 1 were used as organic solvents of the chemical liquid. The abbreviations are as follows.
- PGMEA: propylene glycol monomethyl ether acetate
- PGME: propylene glycol monomethyl ether
- PGME/PGMEA(7:3): a mixed liquid of PGME and PGMEA at 7:3 (volume ratio)

### <Purification>

The above organic solvents were purified by performing a filtration step using the filters shown in Table 1 after the distillation step shown below. Purification was performed by appropriately changing the number of passes of the liquid through the filter in the filtration step. In the case of the mixed liquid (PGME/PGMEA (7:3, volume ratio)), the organic solvents before mixing (respective liquids) were each individually distilled, and then mixed at a predetermined ratio to obtain a mixed liquid, and the mixed liquid was filtered using a filter.

### (Distillation Step)

A commercially available organic solvent was subjected to distillation treatment including dehydration one or more times to prepare an organic solvent having reduced impurities. The water content in each organic solvent after distillation was 100 ppm or less.

### (Filtration Step)

After the distillation step, filtration using the following filters was performed. Each filter was pre-wetted by passing 8 L of each organic solvent through the filter under a pressurized condition of 0.1 MPa before use for filtration. The filters used in each Example and each Comparative Example are shown in Table 1. In Comparative Example 2, first-stage filtration was first performed using Filter 1, and then second-stage filtration was performed using Filter 2.
- Filter 1: "Microgard(TM) UPE" (filter name), manufactured by Entegris, Inc., 1 nm (pore diameter)
- Filter 2: "Purasol(TM) SP" (filter name), manufactured by Entegris, Inc., 200 nm (pore diameter)
- Filter 3: "Microgard UPE" (filter name), manufactured by Entegris, Inc., 10 nm (pore diameter)

**[Table 1]**

| | Organic solvent (volume ratio) | Filter |
|---|---|---|
| Example 1 | PGMEA | Filter 1 |
| Example 2 | PGMEA | Filter 1 |
| Example 3 | PGMEA | Filter 1 |
| Example 4 | PGME/PGMEA(7:3) | Filter 1 |
| Example 5 | PGME/PGMEA(7:3) | Filter 1 |
| Example 6 | PGME/PGMEA(7:3) | Filter 1 |
| Example 7 | PGME | Filter 1 |
| Example 8 | Cyclohexanone | Filter 1 |
| Example 9 | Cyclopentanone | Filter 1 |
| Example 10 | 2-Heptanone | Filter 1 |
| Example 11 | γ-Butyrolactone | Filter 1 |
| Example 12 | Ethyl lactate | Filter 1 |
| Example 13 | Butyl acetate | Filter 1 |
| Example 14 | 3-Methoxybutyl acetate | Filter 1 |
| Comparative Example 1 | PGMEA | Filter 1 |
| Comparative Example 2 | PGMEA | Filter 1 (first stage) |
| | | Filter 2 (second stage) |
| Comparative Example 3 | PGMEA | Filter 3 |
| Comparative Example 4 | PGMEA | Filter 3 |

### <Container>

As the container for containing the chemical liquid, a container having a liquid-contact portion made of the following material was used.
- "GEP": an austenitic stainless steel subjected to passivation treatment (as the passivation treatment, heat oxidation treatment (GEP treatment) was performed after electro polishing (EP) was performed. That is, the container is a container that includes an austenitic stainless steel subjected to heat oxidation treatment as passivation treatment as a base material, and has a surface subjected to the passivation treatment (heat-oxidized surface) as an inner surface of the container.
- "SUS": austenitic stainless steel not subjected to passivation treatment (no passivation treatment, no heat oxidation treatment, and with electro polishing), that is, the container is a container that includes austenitic stainless steel not subjected to passivation treatment as a base material, and the austenitic stainless steel forms an inner surface of the container.

### <Measurement Conditions>

### (Content of Metal Component)

The content of the metal component in the chemical liquid immediately after chemical-liquid containment (meaning immediately after the chemical liquid was contained in the container and the chemical liquid was sealed) and after 30 days had elapsed (stored for 30 days from filling) was measured using plasma mass spectrometry (ICP-MS, apparatus name "Agilent 8900 ICP-QQQ", manufactured by Agilent Technologies, Inc.).

### (Evaluation of Increase Rate of Particles in Liquid)

The measured value of particles in the liquid (LPC value) of the chemical liquid of each Example and each Comparative Example was obtained by measuring, at 25°C, the number of particles having a diameter of 30 nm or more (number per 1 mL (particles/mL)) using a liquid-borne particle counter ("KS-19F", manufactured by RION Co., Ltd.). The LPC value (X) immediately after the chemical liquid was contained in the container and the LPC value (Y) after a predetermined number of days had elapsed were respectively measured, and the increase rate of the LPC value after the predetermined number of days had elapsed relative to the LPC value immediately after chemical-liquid filling (Y/X) (increase rate of particles in the liquid) was calculated. When the shape of the particles was not circular, for example, when the shape was irregular, the above diameter was defined as the maximum major diameter of the irregular shape.

Then, the increase rate of particles in the liquid was evaluated based on the following criteria.
A: The increase rate of the number of particles was 500% or less.
B: The increase rate of the number of particles was more than 500% and less than 1000%.
C: The increase rate of the number of particles was 1000% or more.

### (Evaluation of Defect Suppression Properties)

Defect inspection of a 12-inch (diameter: 300 mm) silicon wafer used for inspection was performed using a dark-field defect inspection apparatus ("Surfscan(TM) SP5", manufactured by KLA-Tencor Corporation).

First, the number of defects (defect count) having a size with a diameter of 17 nm or more present on the surface of the silicon wafer was measured using the dark-field defect inspection apparatus (this was defined as the "initial value").

Next, the above substrate was set in a spin dispensing apparatus, and while the substrate was rotated under a condition of a rotation speed of 1000 rpm, 5 mL of the chemical liquid contained in the container was dispensed onto the surface of the substrate at a flow rate of 1 mL/s. After dispensing, the substrate was spin-dried. Subsequently, using the dark-field defect inspection apparatus, the number of defects having a diameter of 17 nm or more present on the substrate after application of the chemical liquid was measured (this was defined as the "measured value"). When the shape of the defect was not circular, for example, when the shape was irregular, the above diameter was defined as the maximum major diameter of the irregular shape.

Then, the number of generated defects was determined by obtaining the difference between the "initial value" and the "measured value" (measured value - initial value). Then, defect suppression properties were evaluated based on the following evaluation criteria. As the measurement area, the number of defects observed in an entire surface area of approximately 70650 mm² (=150 mm × 150 mm × 3.14) of the 12-inch (diameter: 300 mm) silicon wafer used for inspection was counted.
A: The number of defects in the measurement area was 100 or less.
B: The number of defects in the measurement area was 101 or more and 500 or less.
C: The number of defects in the measurement area was 501 or more and 1000 or less.
D: The number of defects in the measurement area was 1001 or more.

The conditions and evaluation results of each Example and each Comparative Example are shown in Table 2.

Note that 1 ppm by mass = 1,000,000 ppt by mass.

### [Table 2]

**Table 2**

| | Container | V (ppt by mass) | | Sn (ppt by mass) | | Pb (ppt by mass) | |
|---|---|---|---|---|---|---|---|
| | | Post-filling | Post-elapse | Post-filling | Post-elapse | Post-filling | Post-elapse |
| Example 1 | GEP | 50 | 50 | 30 | 35 | 40 | 48 |
| Example 2 | GEP | 0.2 | 0.6 | 0.1 | 0.9 | 0.5 | 0.6 |
| Example 3 | GEP | 475600 | 475630 | 360090 | 360100 | 160020 | 160360 |
| Example 4 | GEP | 70 | 75 | 20 | 23 | 40 | 47 |
| Example 5 | GEP | 0.3 | 0.8 | 0.4 | 0.9 | 0.3 | 0.6 |
| Example 6 | GEP | 229600 | 229600 | 430090 | 430100 | 340034 | 340052 |
| Example 7 | GEP | 100 | 108 | 51 | 57 | 64 | 69 |
| Example 8 | GEP | 131 | 139 | 24 | 30 | 73 | 80 |
| Example 9 | GEP | 78 | 87 | 67 | 74 | 87 | 95 |
| Example 10 | GEP | 84 | 89 | 48 | 54 | 104 | 110 |
| Example 11 | GEP | 85 | 94 | 34 | 46 | 21 | 27 |
| Example 12 | GEP | 113 | 124 | 31 | 37 | 89 | 95 |
| Example 13 | GEP | 209 | 213 | 100 | 107 | 86 | 97 |
| Example 14 | GEP | 400 | 409 | 76 | 83 | 109 | 121 |
| Comparative Example 1 | SUS | 50 | 1000230 | 40 | 1050000 | 45 | 1900000 |
| Comparative Example 2 | GEP | 0.002 | 0.005 | 0.01 | 0.03 | 0.06 | 0.08 |
| Comparative Example 3 | GEP | 1000560 | 1000560 | 1003400 | 1003405 | 1008090 | 1008091 |
| Comparative Example 4 | GEP | 400560 | 400560 | 423400 | 423405 | 338090 | 338104 |

**Table 2 (continued)**

| | Total metal components | | | Increase rate of particles in liquid | Defect suppression properties |
|---|---|---|---|---|---|
| | (ppt by mass) | | (mass ratio) | | |
| | Post-filling | Post-elapse | Post-elapse/post-filling | | |
| Example 1 | 120 | 133 | 1.11 | A | A |
| Example 2 | 0.8 | 2.1 | 2.63 | A | A |
| Example 3 | 995710 | 996090 | 1.00 | A | B |
| Example 4 | 130 | 145 | 1.12 | A | A |
| Example 5 | 1 | 2.3 | 2.30 | A | A |
| Example 6 | 999724 | 999752 | 1.00 | A | B |
| Example 7 | 215 | 234 | 1.09 | A | A |
| Example 8 | 228 | 249 | 1.09 | A | A |
| Example 9 | 232 | 256 | 1.10 | A | A |
| Example 10 | 236 | 253 | 1.07 | A | A |
| Example 11 | 140 | 167 | 1.19 | A | A |
| Example 12 | 233 | 256 | 1.10 | A | A |
| Example 13 | 395 | 417 | 1.06 | A | A |
| Example 14 | 585 | 613 | 1.05 | A | A |
| Comparative Example 1 | 135 | 3950230 | 29260.96 | C | D |
| Comparative Example 2 | 0.072 | 0.115 | 1.60 | C | C |
| Comparative Example 3 | 3012050 | 3012056 | 1.00 | C | D |
| Comparative Example 4 | 1162050 | 1162069 | 1.00 | C | D |

From the above, it was at least confirmed that the chemical liquids of the present Examples had a low increase rate of particles in the liquid and were also excellent in defect suppression properties.

The present application is based on Japanese Patent Application (Japanese Patent Application No. 2023-221881) filed with the Japan Patent Office on December 27, 2023, the contents of which are incorporated herein by reference.

## Claims

1. A semiconductor-manufacturing chemical liquid packaged in a container, the semiconductor-manufacturing chemical liquid being contained in the container, wherein
the container contains an austenitic stainless steel subjected to passivation treatment as a base material, and a surface subjected to the passivation treatment is an inner surface of the container,
the semiconductor-manufacturing chemical liquid contains one or more metal components selected from the group consisting of V, Sn, and Pb, and an organic solvent, and
a content of the metal component in the semiconductor-manufacturing chemical liquid after 30 days have elapsed from a time of filling into the container is 0.1 ppt by mass to 1 ppm by mass.

2. The semiconductor-manufacturing chemical liquid packaged in a container according to claim 1, wherein
the semiconductor-manufacturing chemical liquid contains two or more metal components selected from the group consisting of V, Sn, and Pb,
a content of each of the two or more metal components in the semiconductor-manufacturing chemical liquid after 30 days have elapsed from a time of filling into the container is 1 ppm by mass or less, and
a content of at least one metal component among the two or more metal components in the semiconductor-manufacturing chemical liquid after 30 days have elapsed from a time of filling into the container is 1 ppt by mass or more.

3. The semiconductor-manufacturing chemical liquid packaged in a container according to claim 1 or 2, wherein
a ratio of a concentration of the metal component in the container after 30 days have elapsed from a time of filling into the container to a concentration of the metal component in the container at the time of filling into the container (after 30 days have elapsed from the time of filling/at the time of filling) is 1 or more and 1.5 or less.

4. The semiconductor-manufacturing chemical liquid packaged in a container according to any one of claims 1 to 3, wherein
the semiconductor-manufacturing chemical liquid contains, as the organic solvent, one or more selected from the group consisting of an alkylene glycol monoalkyl ether, an alkylene glycol monoalkyl ether acetate, cyclohexanone, cyclopentanone, 2-heptanone, γ-butyrolactone, ethyl lactate, butyl acetate, and 3-methoxybutyl acetate.

5. The semiconductor-manufacturing chemical liquid packaged in a container according to any one of claims 1 to 4, wherein
the semiconductor-manufacturing chemical liquid contains two or more of the organic solvents.

6. The semiconductor-manufacturing chemical liquid packaged in a container according to any one of claims 1 to 5, wherein
the passivation treatment is a GEP treatment or a GEPW treatment.

7. The semiconductor-manufacturing chemical liquid packaged in a container according to any one of claims 1 to 6, wherein
the semiconductor-manufacturing chemical liquid is a semiconductor-manufacturing developer or a semiconductor-manufacturing rinse liquid.

8. A method for producing a semiconductor-manufacturing chemical liquid packaged in a container, the semiconductor-manufacturing chemical liquid being contained in the container, the method comprising:
a step of preparing, as the container, a container containing an austenitic stainless steel subjected to passivation treatment as a base material and having a surface subjected to the passivation treatment as an inner surface; and
a step of filling the container with the semiconductor-manufacturing chemical liquid, wherein
the semiconductor-manufacturing chemical liquid contains one or more metal components selected from the group consisting of V, Sn, and Pb, and an organic solvent, and
a content of the metal component in the semiconductor-manufacturing chemical liquid after 30 days have elapsed from a time of filling into the container is 0.1 ppt by mass to 1 ppm by mass.

9. A method for storing a semiconductor-manufacturing chemical liquid, the method comprising:
a step of preparing a container containing an austenitic stainless steel subjected to passivation treatment as a base material and having a surface subjected to the passivation treatment as an inner surface; and
a step of filling the container with a semiconductor-manufacturing chemical liquid, wherein
the semiconductor-manufacturing chemical liquid contains one or more metal components selected from the group consisting of V, Sn, and Pb, and an organic solvent, and
a content of the metal component in the semiconductor-manufacturing chemical liquid after 30 days have elapsed from a time of filling into the container is 0.1 ppt by mass to 1 ppm by mass.
